# EUROPEAN PATENT SPECIFICATION

(11) **EP 2 197 240 B1**
(45) Date of publication and mention of the grant of the patent: **14.09.2016**
(21) Application number: 09252503.9
(22) Date of filing: 29.10.2009
(51) Int. Cl.: H01L 51/52

(54) **LIGHT EMITTING DISPLAY AND METHOD OF MANUFACTURING THE SAME**
LICHTEMITTIERENDE ANZEIGE UND HERSTELLUNGSVERFAHREN DAFÜR
AFFICHAGE ÉLECTROLUMINESCENT ET SON PROCÉDÉ DE FABRICATION

(30) Priority: 29.10.2008 KR 20080106222
(43) Date of publication of application: 16.06.2010
(73) Proprietor: Samsung Display Co., Ltd., Gyeonggi-do (KR)
(72) Inventor: Lee, Sun-Young, Yongin-city Gyunggi-do (KR); Lee, Jong-Hyuk, Yongin-city Gyunggi-do (KR); Cho, Yoon-Hyeung, Yongin-city Gyunggi-do (KR); Oh, Min-Ho, Yongin-city Gyunggi-do (KR); Lee, Byoung-Duk, Yongin-city Gyunggi-do (KR); Lee, So-Young, Yongin-city Gyunggi-do (KR)
(74) Representative: Mounteney, Simon James

(56) References cited:
- EP-A2- 1 811 589
- EP-A2- 1 814 186
- EP-A2- 2 009 715
- WO-A1-98/01910
- WO-A2-2008/012460
- JP-A- 2007 177 207

## Description

### BACKGROUND

### 1. Field of the Invention

The present invention relates to a light emitting display and a method of manufacturing the same, and more particularly to a light emitting display having a silicone filling material between a substrate on which a light emitting device is formed and a sealing substrate, and a method of manufacturing the same.

### 2. Discussion of Related Art

Since a light emitting device such as an organic light emitting diode (OLED) includes organic materials vulnerable to moisture and/or oxygen, it is required to protect the OLED against moisture and/or oxygen.

Since a light emitting display using an OLED typically has a wide viewing angle, high contrast and response speed, and low power consumption, in spite of its vulnerability to moisture and/or oxygen, light emitting displays are widely used in personal portable equipment, such as MP3 players, mobile telephones, and televisions (TV). Light emitting displays have been slimmer in accordance with the requests of users.

However, when the thickness of a substrate of a light emitting display is reduced to about 0.3 mm or less in order to reduce the overall thickness of the light emitting display, it is difficult to maintain the mechanical integrity of the device under stresses such as falling and twisting. Loss of mechanical integrity can compromise the sealed state of the device, thereby reducing the life of the organic light emitting display.

WO2008/012460 discloses a light emitting display according to the precharacterising portion of claim 1.

### SUMMARY OF THE INVENTION

Accordingly, it is an object to provide a light emitting display capable of securing mechanical reliability and of durability and a method of manufacturing the same.

It is another object to provide a light emitting display capable of securing mechanical reliability by using an inorganic sealing material that effectively prevents the infiltration of moisture or oxygen and a method of manufacturing the same.

In order to achieve the foregoing and/or other objects, according to one aspect of the present invention, there is provided a light emitting display according to claim 1.

The dam member may comprise an inorganic material. The inorganic material may comprise frit.

A reflecting layer may be arranged to reflect a laser and/or infrared rays is disposed on a surface of the dam member. The reflecting layer may comprise at least one selected from the group consisting of Au, Ag, Pt, and Al.

The dam member may be disposed to be in contact with the inorganic sealing material.

The dam member may comprise an organic material. The organic material may comprise at least one selected from the group consisting of epoxy, epoxy acrylate, bisphenol A type epoxy, cycloaliphatic epoxy resin, phenyl silicone resin, or rubber, and acrylic epoxy resin.

The dam member may be disposed to be spaced away from the inorganic sealing material. The dam member and the inorganic sealing material may be spaced away from each other by 50 µm or more.

The inorganic sealing material may comprise frit. The frit may be melted by a laser and/or infrared rays. The frit may comprise a transition metal compound

In order to achieve the foregoing and/or other objects, according to another aspect of the present invention, there is provided a method of manufacturing a light emitting display according to claim 9.

The present invention as described above seals the light emitting devices using an inorganic sealing material effectively preventing hydrogen or oxygen from penetrating and fill space between the substrates with a silicon filling material to improve pressure resistance. The silicon filling material has a high stability as it does not react to the material of the light emitting device. Further, it maintains pressure resistance between the substrates to allow the sealed state not to be easily broken by means of impact or the like. Therefore, the mechanical reliability is improved so that the life of the light emitting display can be increased, and a passivation film for protecting a cathode electrode is omitted so that the manufacturing process can be simplified.

Forming the inorganic sealing material may comprise applying frit paste; and drying or annealing the applied frit paste.

Forming the dam member may comprise applying frit paste; and drying or annealing the applied frit paste and hardening the frit paste.

The dam member may be formed to be in contact with the inorganic sealing material. Forming the dam member may comprise: applying a liquid organic material to be spaced away from the inorganic sealing material; and pre-hardening the applied liquid organic material.

Disposing the first substrate and the second substrate to face each other may be performed at a pressure lower than atmospheric pressure.

The method may further comprise compressing the first substrate and the second substrate so that the silicon filling material fills the space between the first substrate and the second substrate inside the dam member.

The sealing the light emitting devices may further comprise attaching the first substrate to the second substrate by melting the inorganic sealing material. The inorganic sealing material may be melted by a laser or infrared rays.

The silicon filling material may be hardened using any one of heat, an electron beam and ultraviolet rays.

Also, in typical light emitting displays, since the space between the substrate and the sealing substrate is empty, the substrate may droop to cause the generation of Newton's ring or the displays may be vulnerable to impact. On the other hand, in the light emitting display according to the present invention, the space between the substrate and the sealing substrate is filled with a filling material having a similar refractivity to the glass substrate, thereby preventing Newton's ring and having improved visibility.

According to a first aspect of the invention, there is provided a light emitting display as set out in Claim 1. Preferred features of this aspect are set out in Claims 2 to 8.

According to a second aspect of the invention, there is provided a method as set out in Claim 9. Preferred features of this aspect are set out in Claims 10 to 16.

### BRIEF DESCRIPTION OF THE DRAWINGS

These and/or other aspects and advantages of the invention will become apparent and more readily appreciated from the following description of the preferred embodiments, taken in conjunction with the accompanying drawings of which:
FIG. 1 is a perspective view illustrating a light emitting display according to an embodiment of the present invention;
FIG. 2 is a cross-sectional view taken along line I1-I2 of FIG. 1;
FIG. 3 is a cross-sectional view of the light emitting device of FIG. 1;
FIGS. 4A and 4B are plan views illustrating a method of manufacturing the light emitting display according to the present invention; and
FIGS. 5A to 5F are cross-sectional views illustrating a method of manufacturing the light emitting display according to the present invention.

### DETAILED DESCRIPTION OF PREFERRED EMBODIMENTS

In the following detailed description, only certain exemplary embodiments of the present invention have been shown and described, simply by way of illustration. As those skilled in the art would realize, the described embodiments may be modified in various different ways, all without departing from the spirit or scope of the present invention. Accordingly, the drawings and description are to be regarded as illustrative in nature and not restrictive. In addition, when an element is referred to as being "on" another element, it can be directly on the element or be indirectly on the element with one or more intervening elements interposed therebetween. Also, when an element is referred to as being "connected to" another element, it can be directly connected to the element or be indirectly connected to the element with one or more intervening elements interposed therebetween. Hereinafter, like reference numerals refer to like elements.

Hereinafter, exemplary embodiments of the present invention will be described in detail with reference to the accompanying drawings. However, the embodiments set forth herein are provided so that those skilled in the art can fully understand the present invention and thus, the present invention can be embodied in different forms and should not be construed as limited to the embodiments set forth herein.

In order to increase the life of an organic light emitting display, it is effective to use an inorganic sealing material that effectively prevents moisture and/or oxygen from penetrating. However, the inorganic sealing material is easily separated by means of impact or warp to deteriorate mechanical reliability.

Therefore, embodiments of the present invention provide a light emitting display which is increased in life and improved in mechanical reliability by using an inorganic sealing material that effectively prevents moisture and/or oxygen from penetrating and a method of manufacturing the same.

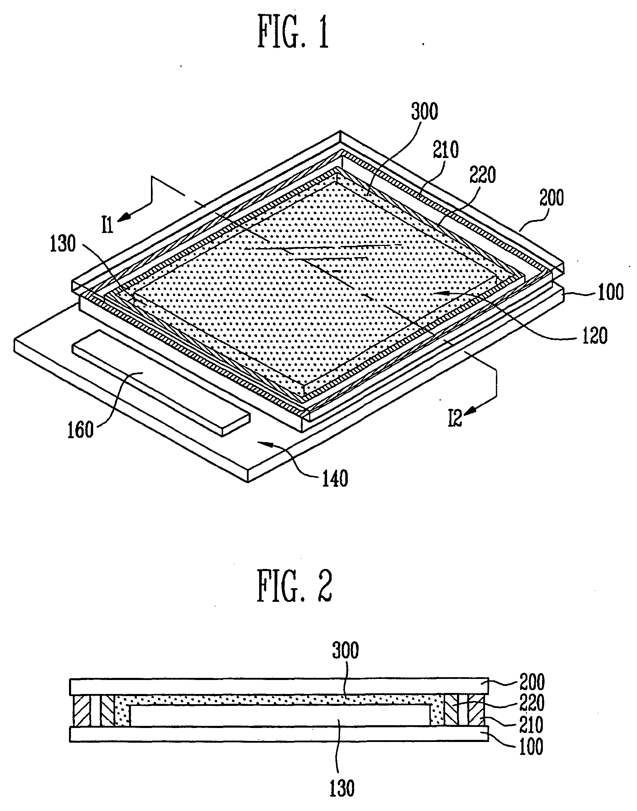

FIG. 1 is a perspective view illustrating a light emitting display according to an embodiment of the present invention, and FIG. 2 is a cross-sectional view taken along line I1-I2 of FIG. 1.

Referring to FIGS. 1 and 2, the light emitting display of this embodiment of the present invention includes a substrate 100 on which a plurality of light emitting devices 130 are formed, a sealing substrate 200 facing the substrate 100, a dam member 220 provided between the substrate and the sealing substrate 200 to surround the plurality of light emitting devices 130, an inorganic sealing material 210 provided outside the dam member 220 between the substrate 100 and the sealing substrate 200 and attaching the substrate 100 to the sealing substrate 200, and a silicone filling material 300 provided inside the dam member 220 between the substrate 100 and the sealing substrate 200.

The substrate 100 is defined as a pixel region 120 and a non-pixel region 140 around the pixel region 120. The plurality of light emitting devices 130 are formed in the pixel region 120, and a driving circuit 160 for driving the plurality of light emitting devices 130 is formed in the non-pixel region 140.

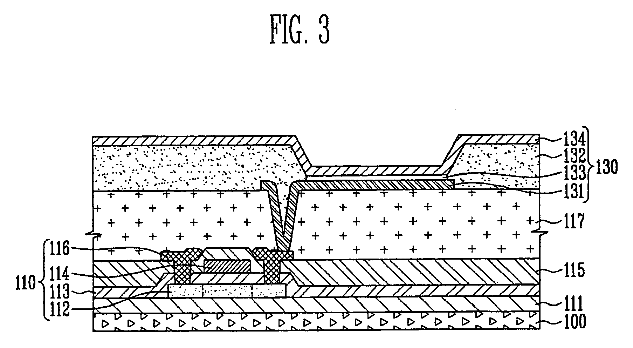

Referring to FIG. 3, the light emitting device 130, for example, may be formed of an organic light emitting display that includes an anode electrode 131, a cathode electrode 134 and an organic light emitting layer 133 formed between the anode electrode 131 and the cathode electrode 134. The organic light emitting layer 133 is formed in a light emitting region (a region where the anode electrode 131 is exposed) defined by a pixel definition layer 132 and may include a hole injection layer, a hole transport layer, an electron transport layer and an electron injection layer.

Also, a thin film transistor for controlling the operation and a capacitor for maintaining a signal may be coupled to the light emitting device 130. The thin film transistor 110 includes a semiconductor layer 112 providing a source and drain region and a channel region, a gate electrode 114 insulated from the semiconductor layer by a gate insulating layer 113, and a source and drain electrode 116 coupled to the semiconductor layer 112 in the source and drain region through a contact hole formed on the insulating layer 115 and the gate insulating layer 113. Reference numerals 111 and 117, not explained, are a buffer layer and a planarization layer, respectively.

The sealing substrate 200 is disposed to overlap with the pixel region 120 and a part of the non-pixel region 140. In the case of a front emission type of display, the sealing substrate 200 can be formed of a transparent material such as glass. In the case of a rear emission type, the sealing substrate can be formed of an opaque material.

The inorganic sealing material 210 includes frit, which is melted by a laser or infrared rays to be attached to the substrate 100 and the sealing substrate 200. The inorganic sealing material 210 is provided between the substrate 100 and the sealing substrate 200 to surround the light emitting device 130 so that moisture or oxygen penetration from the outside is prevented.

The dam member 220 prevents the filling material 300 from flowing so that the shape of the filling material 300 is maintained. The dam member 220 is provided to prevent heat from being transmitted to the light emitting devices 130 when the inorganic sealing material 210 is attached to the substrate 100 and the sealing substrate 200 and formed of an inorganic material or an organic material.

The inorganic material includes frit. In this case, frit that transmits or reflects a laser or infrared rays is used or a reflecting layer is formed on the surface of the dam member 220 using metal having a high reflectance in the infrared region, e.g., Au, Ag, Pt, and/or A1, so that a laser or Infrared rays is reflected. In addition, as an organic material, at least one selected from the group consisting of epoxy, epoxy acrylate, and silicones (e.g., bisphenol A type epoxy, cycloaliphatic epoxy resin, phenyl silicone resin or rubber, acrylic epoxy resin, etc. and).

The dam member 220 may be formed to be in contact with the inorganic sealing material 210 or may be parallel separated from the inorganic sealing material 210 by a predetermined distance. For example, the dam member 220 may be formed to be in contact with the inorganic sealing material 210 when including an inorganic material, while it may be separated from the inorganic sealing material 210 by about 50 µm or more when including an organic material. If the dam member 220 of an organic material is in contact with the inorganic sealing material 210, it may be decomposed by heat when the inorganic sealing material 210 is attached to the substrate 100 and the sealing substrate 200 to generate out gas.

The silicone filling material 300 is provided to fill an inward space between the substrate 100 and the sealing substrate 200 defined by the dam member 220. The silicone filling material 300 is, in this embodiment, a colorless (transparent) material having a transmittance of not less than 90% in a visible region, such as a glass substrate, so that visibility does not deteriorate. Also, the silicone filling material 300 has a high stability in view of chemistry so that it does not react to a material forming the light emitting devices 130, in particular, the cathode electrode 134 formed of a metal material. In some embodiments, the silicone filling material 300 can be formed from: a vinyl polymer such as polyalkylalkenyl siloxane, polyalkylphenyl siloxane, polyalkylphenylalkenyl siloxane, etc; an H-polymer such as polyalkylhydrogen siloxane, polyalkylphenylhydrogen siloxane etc; a hardening catalyzer, an anti-hardening agent etc. In other embodiments, other silicone filling materials could be used.

In order to protect the cathode electrode 134 after the light emitting device 130 is formed as shown in FIG. 3, an organic or inorganic passivation film (not shown) should be formed on the cathode electrode 134. In this case, an additional process is required and the display increases in thickness. However, since embodiments of the present invention use the filling material 300 which does not react to a metal material, it can be implemented to have a structure where the cathode electrode 134 is exposed, making it possible to simplify the process and structure thereof.

Hereinafter, a method of manufacturing a light emitting display according to some embodiments of the present invention will be described in detail.

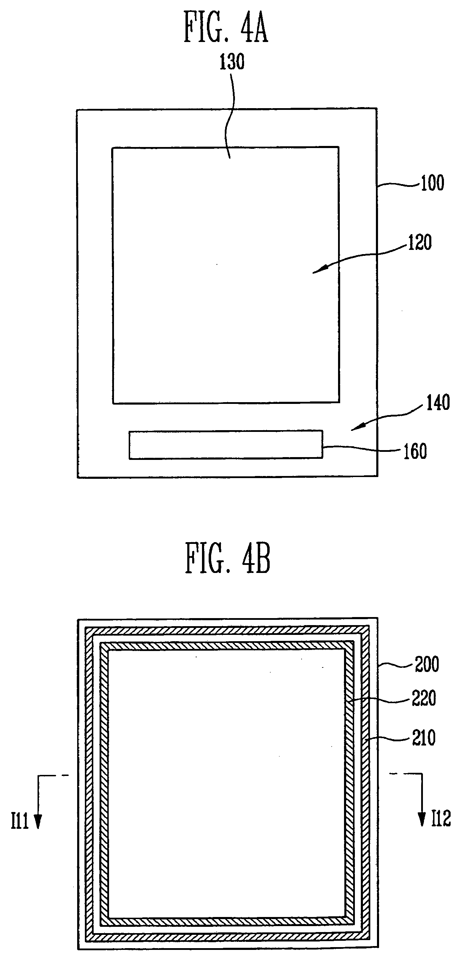

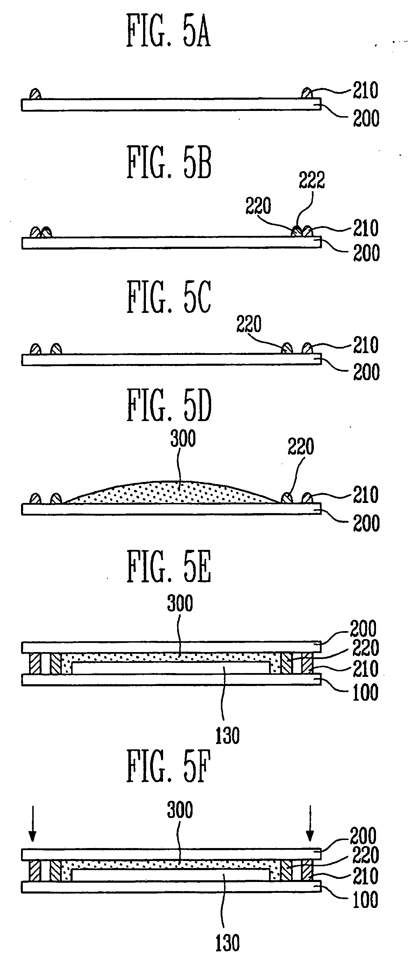

FIGS. 4A and 4B are plan views illustrating a method of manufacturing the light emitting display according to an embodiment of the present invention. FIGS. 5A to 5F are cross-sectional views illustrating the method of manufacturing the light emitting display according to an embodiment of the present invention. FIGS. 5A to 5D are cross-sectional views taken along line I11-I12 of FIG. 4B.

Referring to FIG. 4A, first, the substrate 100 on which the plurality of light emitting devices 130 are formed is provided. The substrate 100 is divided into the pixel region 120 and the non-pixel region 140 around the pixel region 120. The plurality of light emitting devices 130 are formed in the pixel region 120 of the substrate, and the driving circuit 160 for driving the light emitting devices 130 are formed in the non-pixel region 140.

Referring to FIG. 3, the light emitting devices 130 include an organic light emitting device having the anode electrodes 131, the organic light emitting layers 133, and the cathode electrodes 134. Also, the light emitting devices 130 may further include thin film transistors (TFT) 110 for controlling the operation of the organic light emitting device and capacitors (not shown) for maintaining signals. A process of manufacturing the organic light emitting device is illustrated in the Korean Patent Publications No. 2002-0047889 (published on June 22, 2002) and No. 2003-0092873 (published December 6, 2003).

Referring to FIGS. 4B and 5A, the sealing substrate 200 for sealing the light emitting devices 130 of the pixel region 120 is provided. The sealing substrate 200 may overlap with the pixel region 120 and a part of the non-pixel region 140. A transparent substrate such as glass having the front emission structure or an opaque substrate having the rear emission type can be used as the sealing substrate 200.

An inorganic sealing material 210 is disposed along the edge of the sealing substrate 200. The inorganic sealing material 210 is formed by applying frit using a dispenser or using a screen printing method. Frit commonly means a powder-type glass material. However, as used herein, frit refers to paste containing a laser or infrared-ray absorbing material, an organic binder, and a filler to reduce a thermal expansion coefficient, in a main material such as SiO2. The organic binder and moisture are removed from the paste frit via a drying or annealing process so that the paste frit is hardened. The laser or infrared-ray absorbing material can include a transition metal compound, for example, a vanadium compound. After the inorganic sealing material 210 is disposed on the sealing substrate 200, a washing process can be followed.

Referring to FIGS. 4B, 5B, and 5C, the dam member 220 is formed on the sealing substrate 200 on the inward side of the inorganic sealing material 210 to surround the pixel region 120. The dam member 220 may be formed by applying an inorganic material or an organic material by dispensers or by screen printing. At this time, the amount of the inorganic material or organic material is determined in consideration of the distance from the light emitting devices 130 disposed in the outermost region of the pixel region to the inorganic sealing material 210 and the height of the dam member 220. The height of the dam member 220 may be determined by the height of the inorganic sealing material 210 and is preferably the same or less than the height of the inorganic sealing material 210.

Frit can be used as the inorganic material. In this case, the dam member 220 can be formed in a process of forming the inorganic sealing material 210. Frit that transmits or reflects a laser or infrared rays is used or a reflecting layer 222 is disposed on the surface of the dam member 220 in order to reflect a laser or ultraviolet rays as illustrated in FIG. 5B. For example, after applying the paste frit, the paste frit is dried or annealed, and hardened to form the dam member 220. Then, a metal such as Au, Ag, Pt, or A1 having a high reflectance in the ultraviolet-rays region is applied onto the surface of the dam member 220 to form the reflecting layer 222. In addition, the organic material can be at least one selected from the group consisting of epoxy, epoxy acrylate, and silicones (e.g., bisphenol A type epoxy, cycloaliphatic epoxy resin, phenyl silicone resin or rubber, acrylic epoxy resin, etc.).

The dam member 220 may be formed to be in contact with the inorganic sealing material 210, as illustrated in FIG. 5B, or to be separated from the inorganic sealing material 210 by a predetermined distance, as illustrated in FIG. 5C. For example, when being formed of an inorganic material, the dam member 220 can be in contact with the inorganic sealing material 210. In this case, the area of the non-pixel region can be reduced. In addition, when being formed of an organic material, the dam member 220 is preferably separated from the inorganic sealing material 210 by 50 µm or more. Since the organic material typically has low viscosity to be easily applied, it may be easily collapsed by stress such as a pressure difference. Therefore, the dam member 220 is formed and then is pre-hardened to be solid in structure, the dam function can be reinforced. Therefore, the dam member 220 can be pre-hardened by heat, an electron beam, or ultraviolet rays in accordance with the kind of the organic material so that the dam member 220 is not damaged by the stress in a process of attaching the substrate 100 to the sealing substrate 200.

In another embodiment, in a process of forming the inorganic sealing material 210 or the dam member 220, a dummy sealing material (not shown) can be formed of epoxy and frit on the outermost edge of the sealing substrate 200. The dummy sealing material is formed on the outside of the sealing material 210 to collectively seal up the space between the substrate 100 and the sealing substrate 200. In the case of a mother substrate, the dummy sealing material is disposed along the outermost edge thereof.

Referring to FIG. 5D, the liquid silicone filling material 300 is provided on the sealing substrate 200 in the inward region defined by the dam member 220. The silicone filling material 300 is a colorless (transparent) material having a transmittance of 90% or more in a visible-ray region such as a glass substrate, so that it does not deteriorate visibility. Also, the silicone filling material 300 has a high stability in view of chemistry not to react to a material forming the light emitting devices 130, in particular, the cathode electrode 134 formed of a metal material.

The silicone filling material 300 can be provided by ink-jetting, a dispenser, screen printing, one drop filling (ODF), or the like. For example, the silicone filling material 300 having a viscosity of 1 to 2000cPs may be stacked on the sealing substrate on the internal side of the dam member 220. In this case, the proper amount of the filling material 300 in proportion to the volume of the internal space can be easily controlled.

Referring to FIG. 5E, the substrate 100 is disposed to face the sealing substrate 200. For example, after the substrate 100 is mounted on an upper chuck of an attaching device and the sealing substrate 200 is mounted on a lower chuck of the attaching device, the substrate 100 and the sealing substrate 200 are attached to each other. As the substrate 100 and the sealing substrate 200 are attached to each other, the silicone filling material 300 is contacted with the cathode electrode 134 to fill a space inside the dam member 220 and is prevented from flowing by the dam member 220 so that the shape is maintained. At this time, the substrate 100 and the sealing substrate 200 are attached to each other under a pressure lower than atmospheric pressure so that bubbles or voids are not formed between the substrate 100 and the sealing substrate 200. In addition, the substrate 100 and the sealing substrate 200 are pressed together so that the space between the light emitting devices 130 and the sealing substrate 200 is completely filled with the filling material 300.

Referring to FIG. 5F, a laser or infrared rays are irradiated along the inorganic sealing material 210 with the substrate 100 and the sealing substrate 200 being attached to each other. As the laser or infrared rays are absorbed to generate heat, the inorganic sealing material 210 is attached to the substrate 100 and the sealing substrate 200 by melting, so that the light emitting devices 130 are sealed. Such a sealing process is preferably performed after the dummy sealing material is hardened so that the space between the substrate 100 and the sealing substrate 200 becomes a vacuum.

When a laser or infrared rays are irradiated along the inorganic sealing material 210, a mask or a passivation film (not shown) is used to irradiate a laser or infrared rays to only a desired region. When the dam member 220 includes an inorganic material that transmits or reflects a laser or infrared rays, or when the reflecting layer 222 is formed on the surface of the dam member 220, the mask or the passivation film is disposed only in the pixel region 120 so that a laser or infrared rays are not irradiated. When the dam member 220 includes an organic material, the mask or the passivation film is disposed in the pixel region 120 and the non-pixel region 140 where the dam member 220 is formed so that a laser or infrared rays do not irradiate.

Assuming that a dam member 220 is not formed, since heat generated in irradiating a laser or infrared rays is easily transmitted to the silicone filling material 300, the temperature can suddenly rise to cause damage to the light emitting devices 130. However, in some embodiments the present invention, the transmission of heat is effectively reduced or prevented by the dam member 220, thereby making it possible to maintain the region filled with the silicone filling material 300 and the shape thereof as they are.

Thereafter, the silicone filling material 300 is hardened using heat, an electron beam or ultraviolet rays. At this time, since an out gas may be generated from silicone materials, the proportion of a composition (vinyl polymer, H-polymer, hardening catalyst, anti-hardening agent or the like) is controlled during the preparing process of the silicon filling material 300 not to generate the out gas at the time of hardening. Therefore, out gas is not generated by silicone filling material 300. The silicone filling material 300 can directly contact the cathode electrode 134. Therefore, some embodiments of the invention provide a structure in which an uppermost protective layer is not needed. An example liquid silicone composition suitable for use that does not generate out gas comprises: between 70wt% and 90wt% of vinyl polymer, between 10wt% and 30wt% of H-polymer; between 0.01wt% and 1.0wt% of a platinum compound (hardening catalyzer), and between 0.01wt% and 1.0wt% of anti-hardening agent.

The above embodiment has been described with the inorganic sealing material 210 sealing only the pixel region 120 but does not limit the present invention. In other embodiments, the inorganic sealing material 210 can further seal the driving circuit 160. In addition, according to the above embodiment, the inorganic sealing material 210 and the dam member 220 are formed in a single structure on the sealing substrate 200. In other embodiments, the inorganic sealing material and the dam member can be formed in a double or multiple structure on the substrate 100. For example, the inorganic sealing material 210 may be formed in a double or multiple structure in order to improve a sealing effect, or the dam member 220 may be formed in a double or multiple structure in order to improve a heat shielding effect.

In addition, according to the above embodiment, the filling material 300 is filled before attaching the substrate 100 and the sealing substrate 200 to each other. However, the filling material 300 can be filled after the substrate 100 and the sealing substrate 200 are attached to each other depending on material or characteristics the material. Also, in the embodiment, the inorganic sealing material 210 is attached to the substrate 100 and the sealing substrate 200, and then the silicone filling material 300 is hardened. However, the silicone filling material 300 can be hardened before the inorganic sealing material 210 is attached to the substrate 100 and the sealing substrate 200.

As an experimental example, when the silicone filling material 300 is filled using the ODF process and thermally hardened at a temperature of 100°C or less, no defects in light emitting are observed even if the silicone filling material 300 is exposed to a high temperature of 85°C and a high humidity of 85% for 428 hours.

While the present invention has been described in connection with certain exemplary embodiment, it is to be understood that the invention is not limited to the disclosed embodiment, but, on the contrary, is intended to cover various modifications and equivalent arrangements included within the scope of the appended claims.

## Claims

1. A light emitting display comprising:
a first substrate (100) on which a plurality of light emitting devices (130) comprising first electrodes (131), organic light emitting layers (133), and second electrodes (134) are disposed;
a second substrate (200) disposed to face the first substrate (100);
a dam member (220) disposed between the first substrate (100) and the second substrate (200) to surround the plurality of light emitting devices (130);
an inorganic sealing material (210) disposed between the first substrate (100) and the second substrate (200) in an outer area of the dam member (220) and attaching the first substrate (100) to the second substrate (200); and
a filling material (300) provided between the first substrate (100) and the second substrate (200) inward of the dam member (220) to be in contact with the second electrodes (134);
**characterised in that** the filling material (300) is a silicone filling material comprising: between 70wt% and 90wt% of vinyl polymer, between 10wt% and 30wt% of H-polymer; between 0.01wt% and 1.0wt% of a platinum compound, and between 0.01wt% and 1.0wt% of anti-hardening agent.

2. A light emitting display according to claim 1, wherein the dam member (220) comprises an inorganic material.

3. A light emitting display according to claim 2, wherein the inorganic material comprises frit.

4. A light emitting display according to claim 2 or 3, wherein a reflecting layer (222) arranged to reflect a laser and/or infrared rays is disposed on a surface of the dam member (220), wherein optionally the reflecting layer (222) comprises at least one selected from the group consisting of Au, Ag, Pt, and Al.

5. A light emitting display according to any one of claims 2 to 4, wherein the dam member (220) is disposed to be in contact with the inorganic sealing material.

6. A light emitting display according to claim 1, wherein the dam member (220) comprises an organic material, wherein optionally the organic material comprises at least one selected from the group consisting of epoxy, epoxy acrylate, bisphenol A type epoxy, cycloaliphatic epoxy resin, phenyl silicone resin, or rubber, and acrylic epoxy resin.

7. A light emitting display according to claim 6, wherein the dam member (220) is disposed to be spaced away from the inorganic sealing material, wherein optionally the dam member (220) and the inorganic sealing material are spaced away from each other by 50 µm or more.

8. A light emitting display according to any one of claims 1 to 7, wherein the inorganic sealing material comprises frit, optionally the frit comprising a transition metal compound.

9. A method of manufacturing a light emitting display comprising:
providing a first substrate (100) on which a plurality of light emitting devices (130) comprising first electrodes (131), organic light emitting layers (133), and second electrodes (134) are disposed;
providing a second substrate (200);
forming an inorganic sealing material along an outer area in the second substrate (200);
forming a dam member (220) on the second substrate (200) inside the inorganic sealing material and surrounding the plurality of light emitting devices (134);
dropping a liquid silicone filling material inside the dam member (220);
disposing the first substrate (100) and the second substrate (200) to face each other so that the silicone filling material becomes in contact with the second electrodes (134) and fills a space inside the dam member (134);
attaching the inorganic sealing material to the first substrate (100) and the second substrate (200) to seal the plurality of light emitting devices (130); and hardening the silicone filling material;
wherein the silicone filling material (300) comprises between 70wt% and 90wt% of vinyl polymer, between 10wt% and 30wt% of H-polymer; between 0.01wt% and 1.0wt% of a platinum compound, and between 0.01wt% and 1.0wt% of anti-hardening agent.

10. A method according to claim 9, wherein the forming the dam member (220) comprises:
applying frit paste; and
drying or annealing the applied frit paste and optionally hardening the frit paste.

11. A method according to claim 9 or 10, wherein the dam member (220) is formed to be in contact with the inorganic sealing material.

12. A method according to any one of claims 9 to 11, wherein the forming the dam member (220) comprises:
applying a liquid organic material to be spaced away from the inorganic sealing material; and
pre-hardening the applied liquid organic material.

13. A method according to any one of claim 9 to 12, wherein the disposing the first substrate (100) and the second substrate (200) to face each other is performed at a pressure lower than atmospheric pressure.

14. A method according to any one of claim 9 to 13, further comprising compressing the first substrate (100) and the second substrate (200) so that the silicone filling material fills the space between the first substrate (100) and the second substrate (200) inside the dam member (220).

15. A method according to any one of claims 9 to 14, wherein the sealing the light emitting devices (130) further comprises attaching the first substrate (100) to the second substrate (200) by melting the inorganic sealing material, wherein:
optionally the inorganic sealing material is melted by a laser or infrared rays.

16. A method according to any one of claims 9 to 15, wherein the silicone filling material is hardened using any one of heat, an electron beam and ultraviolet rays.

## Patentansprüche

1. Lichtemittierende Anzeige, umfassend:
ein erstes Substrat (100), auf dem eine Mehrzahl von lichtemittierenden Vorrichtungen (130), umfassend erste Elektroden (131), organische lichtemittierende Schichten (133) und zweite Elektroden (134) angeordnet sind;
ein zweites Substrat (200), welches dem ersten Substrat (100) zugewandt ist;
ein Dammelement (220), welches zwischen dem ersten Substrat (100) und dem zweiten Substrat (200) so angeordnet ist, um die Mehrzahl von lichtemittierenden Vorrichtungen (130) zu umschließen;
ein anorganisches Dichtungsmaterial (210), welches zwischen dem ersten Substrat (100) und dem zweiten Substrat (200) in einem äußeren Bereich des Dammelements (220) angeordnet ist, und welches das erste Substrat (100) mit dem zweiten Substrat (200) verbindet; und
ein Füllmaterial (300), welches zwischen dem ersten Substrat (100) und dem zweiten Substrat (200) einwärts des Dammelements (220) vorgesehen ist, um mit den zweiten Elektroden (134) in Kontakt zu sein;
**dadurch gekennzeichnet, dass** das Füllmaterial (300) ein Silikonfüllmaterial ist, welches umfasst: zwischen 70 Gew.-% und 90 Gew.-% eines Vinylpolymers, zwischen 10 Gew.-% und 30 Gew.-% eines H-Polymers; zwischen 0,01 Gew.-% und 1,0 Gew.-% einer Platinverbindung, und zwischen 0,01 Gew.-% und 1,0 Gew.-% eines Anti-Aushärtungsmittels.

2. Lichtemittierende Anzeige nach Anspruch 1, wobei das Dammelement (220) ein anorganisches Material umfasst.

3. Lichtemittierende Anzeige nach Anspruch 2, wobei das anorganische Material eine Fritte umfasst.

4. Lichtemittierende Anzeige nach Anspruch 2 oder 3, wobei eine reflektierende Schicht (222), welche zum Reflektieren eines Laserstrahls und/oder Infrarotstrahls ausgebildet ist, auf einer Oberfläche des Dammelements (220) angeordnet ist, wobei optional die reflektierende Schicht (222) zumindest einen umfasst, ausgewählt aus der Gruppe bestehend aus Au, Ag, Pt und Al.

5. Lichtemittierende Anzeige nach einem der Ansprüche 2 bis 4, wobei das Dammelement (220) in Kontakt mit dem anorganischen Dichtungsmaterial angeordnet ist.

6. Lichtemittierende Anzeige nach Anspruch 1, wobei das Dammelement (220) ein organisches Material umfasst, wobei optional das organische Material zumindest einen umfasst, ausgewählt aus der Gruppe bestehend aus Epoxid, Epoxyacrylat, Bisphenol-A-Typ Epoxid, cycloaliphatisches Epoxyharz, Phenyl Silikonharz oder Gummi und Acryl-Epoxidharz.

7. Lichtemittierende Anzeige nach Anspruch 6, wobei das Dammelement (220) vom anorganischen Dichtungsmaterial beabstandet angeordnet ist, wobei optional das Dammelement (220) und das anorganische Dichtungsmaterial um 50 µm oder mehr voneinander beabstandet sind.

8. Lichtemittierende Anzeige nach einem der Ansprüche 1 bis 7, wobei das anorganische Dichtungsmaterial Fritte umfasst, wobei die Fritte optional eine Übergangsmetallverbindung umfasst.

9. Verfahren zur Herstellung einer lichtemittierenden Anzeige, umfassend:
Bereitstellen eines ersten Substrats (100), auf dem eine Mehrzahl von lichtemittierenden Vorrichtungen (130) mit ersten Elektroden (131), organischen lichtemittierenden Schichten (133) und zweite Elektroden (134) angeordnet sind;
Bereitstellen eines zweiten Substrats (200);
Bilden eines anorganischen Dichtungsmaterials entlang einer Außenfläche in dem zweiten Substrat (200);
Bilden eines Dammelements (220) auf dem zweiten Substrat (200) im Inneren des anorganischen Dichtungsmaterials, umschließend die Mehrzahl von lichtemittierenden Vorrichtungen (134);
Fallenlassen eines flüssigen Silikonfüllmaterials im Inneren des Dammelements (220);
Anordnen des ersten Substrats (100) und des zweiten Substrats (200) so dass sie gegeneinander zugewandt sind, so dass das Silikonfüllmaterial in Kontakt mit den zweiten Elektroden (134) gelangt und einen Raum innerhalb des Dammelements (134) ausfüllt;
Befestigen des anorganischen Dichtungsmaterials an das erste Substrat (100) und an das zweite Substrat (200) um die Mehrzahl von lichtemittierenden Vorrichtungen (130) abzudichten; und
Härten des Silikon-Füllmaterials;
wobei das Silikonfüllmaterial (300) zwischen 70 Gew.-% und 90 Gew.-% eines Vinylpolymers, zwischen 10 Gew.-% und 30 Gew.-% eines H-Polymers; zwischen 0,01 Gew.-% und 1,0 Gew.-% einer Platinverbindung, und zwischen 0,01 Gew.-% und 1,0 Gew.-% eines Anti-Aushärtungsmittels umfasst.

10. Verfahren nach Anspruch 9, wobei das Bilden des Dammelements (220) umfasst:
Aufbringen einer Frittenpaste; und
Trocknen oder Glühen der aufgebrachten Frittenpaste und optionales Härten der Frittenpaste.

11. Verfahren nach Anspruch 9 oder 10, wobei das Dammelement (220) ausgebildet ist, um in Kontakt mit dem anorganischen Dichtungsmaterial zu sein.

12. Verfahren nach einem der Ansprüche 9 bis 11, wobei das Bilden des Dammelements (220) umfasst:
Auftragen eines flüssigen organischen Materials, so dass es vom anorganischen Dichtungsmaterial beabstandet ist; und
Vorhärten des aufgebrachten flüssigen organischen Materials.

13. Verfahren nach einem der Ansprüche 9 bis 12, wobei das gegenüberliegende Anordnen des ersten Substrats (100) und des zweiten Substrats (200) bei einem Druck ausgeführt wird, welcher unter dem Atmosphärendruck liegt.

14. Verfahren nach einem der Ansprüche 9 bis 13, ferner umfassend das Verdichten des ersten Substrats (100) und des zweiten Substrats (200) so dass das Silikonfüllmaterial den Raum zwischen dem ersten Substrat (100) und dem zweiten Substrat (200) innerhalb des Dammelements (220) ausfüllt.

15. Verfahren nach einem der Ansprüche 9 bis 14, wobei das Abdichten der lichtemittierenden Vorrichtungen (130) ferner das Befestigen des ersten Substrats (100) an das zweite Substrat (200) durch Schmelzen des anorganischen Dichtungsmaterials umfasst, wobei:
das anorganische Dichtungsmaterial optional mittels eines Lasers oder Infrarotstrahlung geschmolzen wird.

16. Verfahren nach einem der Ansprüche 9 bis 15, wobei das Silikonfüllmaterial gehärtet wird, indem irgendeines von Wärme, einem Elektronenstrahl und ultravioletter Strahlung verwendet wird.

## Revendications

1. Affichage électroluminescent, comprenant :
un premier substrat (100) sur lequel sont agencés une pluralité de dispositifs électroluminescents (130) comprenant des premières électrodes (131), des couches électroluminescentes organiques (133), et des deuxièmes électrodes (134) ;
un deuxième substrat (200) agencé de manière à faire face au premier substrat (100) ;
un élément formant barrage (220) agencé entre le premier substrat (100) et le deuxième substrat (200) afin d'entourer la pluralité de dispositifs électroluminescents (130) ;
un matériau d'étanchéité minéral (210) agencé entre le premier substrat (100) et le deuxième substrat (200) dans une zone extérieure de l'élément formant barrage (220) et qui fixe le premier substrat (100) au deuxième substrat (200) ; et
un matériau de remplissage (300) fourni entre le premier substrat (100) et le deuxième substrat (200) vers l'intérieur de l'élément formant barrage (220) afin d'être en contact avec les deuxièmes électrodes (134) ;
**caractérisé en ce que** le matériau de remplissage (300) est un matériau de remplissage au silicone comprenant : entre 70 % en poids et 90 % en poids de polymère de vinyle, entre 10 % en poids et 30 % en poids de polymère de H, entre 0,01 % en poids et 1,0 % en poids d'un composé au platine, et entre 0,01 % en poids et 1,0 % en poids d'un agent anti-durcissant.

2. Affichage électroluminescent selon la revendication 1, dans lequel l'élément formant barrage (220) comprend un matériau minéral.

3. Affichage électroluminescent selon la revendication 2, dans lequel le matériau minéral comprend une fritte.

4. Affichage électroluminescent selon la revendication 2 ou 3, dans lequel une couche réfléchissante (222) disposée de manière à réfléchir des rayons laser et/ou infrarouges est agencée sur une surface de l'élément formant barrage (220), dans lequel éventuellement la couche réfléchissante (222) comprend au moins un élément sélectionné parmi le groupe constitué de Au, Ag, Pt, et Al.

5. Affichage électroluminescent selon l'une quelconque des revendications 2 à 4, dans lequel l'élément formant barrage (220) est agencé de manière à être en contact avec le matériau d'étanchéité minéral.

6. Affichage électroluminescent selon la revendication 1, dans lequel l'élément formant barrage (220) comprend un matériau organique, dans lequel éventuellement le matériau organique comprend au moins un élément sélectionné parmi le groupe constitué d'époxy, époxy acrylate, époxy de type bisphénol A, résine époxy cycloaliphatique, résine silicone phénylique, ou caoutchouc, et résine époxy acrylique.

7. Affichage électroluminescent selon la revendication 6, dans lequel l'élément formant barrage (220) est agencé de manière à être espacé par rapport au matériau d'étanchéité minéral, dans lequel éventuellement l'élément formant barrage (220) et le matériau d'étanchéité minéral sont espacés l'un par rapport à l'autre de 50 µm ou davantage.

8. Affichage électroluminescent selon l'une quelconque des revendications 1 à 7, dans lequel le matériau d'étanchéité minéral comprend une fritte, ladite fritte comprenant éventuellement un composé à base d'un métal de transition.

9. Procédé de fabrication d'un affichage électroluminescent, comprenant les étapes consistant à :
fournir un premier substrat (100) sur lequel sont agencés une pluralité de dispositifs électroluminescents (130) comprenant des premières électrodes (131), des couches électroluminescentes organiques (133), et des deuxièmes électrodes (134) ;
fournir un deuxième substrat (200) ;
former un matériau d'étanchéité minéral le long d'une zone extérieure dans le deuxième substrat (200) ;
former un élément formant barrage (220) sur le deuxième substrat (200) à l'intérieur du matériau d'étanchéité minéral et autour de la pluralité de dispositifs électroluminescents (134) ;
faire couler un matériau de remplissage au silicone liquide à l'intérieur de l'élément formant barrage (220) ;
agencer le premier substrat (100) et le deuxième substrat (200) de manière à ce qu'ils soient l'un en face de l'autre de telle manière que le matériau de remplissage au silicone vient en contact avec les deuxièmes électrodes (134) et remplit un espace situé à l'intérieur de l'élément formant barrage (134) ;
fixer le matériau d'étanchéité minéral sur le premier substrat (100) et sur le deuxième substrat (200) afin d'étanchéifier la pluralité de dispositifs électroluminescents (130) ; et
durcir le matériau de remplissage au silicone ;
dans lequel le matériau de remplissage au silicone (300) comprend entre 70 % en poids et 90 % en poids de polymère de vinyle, entre 10 % en poids et 30 % en poids de polymère de H, entre 0,01 % en poids et 1,0 % en poids d'un composé au platine, et entre 0,01 % en poids et 1,0 % en poids d'un agent anti-durcissant.

10. Procédé selon la revendication 9, dans lequel l'étape de formation de l'élément formant barrage (220) comprend les étapes consistant à :
appliquer une pâte de fritte ; et
sécher ou recuire la pâte de fritte appliquée et éventuellement durcir la pâte de fritte.

11. Procédé selon la revendication 9 ou 10, dans lequel l'élément formant barrage (220) est formé de manière à être en contact avec le matériau d'étanchéité minéral.

12. Procédé selon l'une quelconque des revendications 9 à 11, dans lequel l'étape de formation de l'élément formant barrage (220) comprend les étapes consistant à :
appliquer un matériau organique liquide de manière à ce qu'il soit espacé par rapport au matériau d'étanchéité minéral ; et
pré-durcir le matériau organique liquide appliqué.

13. Procédé selon l'une quelconque des revendications 9 à 12, dans lequel l'étape d'agencement du premier substrat (100) et du deuxième substrat (200) de manière à ce qu'ils soient l'un en face de l'autre est mise en oeuvre à une pression inférieure à la pression atmosphérique.

14. Procédé selon l'une quelconque des revendications 9 à 13, comprenant en outre une étape consistant à comprimer le premier substrat (100) et le deuxième substrat (200) de telle manière que le matériau de remplissage au silicone remplit l'espace situé entre le premier substrat (100) et le deuxième substrat (200) à l'intérieur de l'élément formant barrage (220).

15. Procédé selon l'une quelconque des revendications 9 à 14, dans lequel l'étape d'étanchéification des dispositifs électroluminescents (130) comprend en outre une étape consistant à fixer le premier substrat (100) sur le deuxième substrat (200) en faisant fondre le matériau d'étanchéité minéral,
dans lequel :
le matériau d'étanchéité minéral est éventuellement fondu grâce à des rayons laser ou infrarouges.

16. Procédé selon l'une quelconque des revendications 9 à 15, dans lequel le matériau de remplissage au silicone est durci en utilisant l'un quelconque parmi de la chaleur, un faisceau d'électrons et des rayons ultraviolets.
